# EUROPEAN PATENT APPLICATION

(11) **EP 0 706 225 A1**
(43) Date of publication of application: **10.04.1996**
(21) Application number: 95305803.9
(22) Date of filing: 21.08.1995
(51) Int. Cl.: H01L 31/0352

(54) **Optical communication system comprising a resonant tunneling diode**

(30) Priority: 19.08.1994 US 293766; 19.08.1994 US 293767
(71) Applicant: TEXAS INSTRUMENTS INCORPORATED, Dallas, Texas 75243 (US)
(72) Inventor: Moise, Theodore S., Dallas, Texas 75229 (US); Magel, Gregory A., Dallas, Texas 75230 (US)
(74) Representative: Brown, Angela Mary

(57) **Abstract**

An optical interconnection system (300) for electronic circuitry with laser emitters (306-308), optical links (310) for transmission of optical signals, and optical modulators (322-324) and transparent detectors (312-314) connected to electronic circuitry to couple optical signals and electrical signals. Each transparent detector (312-314) includes a double barrier quantum well resonant tunneling diode abutting a photosensitive quantum well local electric field enhancer. The photosensitive quantum well absorbs only a few percent of input light and thus provides high fanout.

## Description

### BACKGROUND OF THE INVENTION

The invention relates to electronic systems and devices, and, more particularly, to optical communication systems with photosensitive devices and methods.

The continual demand for enhanced transistor and integrated circuit performance has driven improvements to existing devices, such as silicon bipolar and CMOS transistors and gallium arsenide MESFETs, and also the introduction of new device types and materials. In particular, the demand for low noise and high power at microwave frequencies has led to high electron mobility transistors (HEMTs) made of combinations of gallium arsenide (GaAs) plus aluminum gallium arsenide (AlₓGa₁₋ₓAs) and pseudomorphic HEMTs made of combinations of AlₓGa₁₋ₓAs and indium gallium arsenide (InₓGa₁₋ₓAs) in a MESFET-like structure. Similarly, heterojunction bipolar transistors (HBTs) made of wide bandgap emitters with narrow bandgap bases (e.g., AlₓGa₁₋ₓAs emitters with GaAs bases or silicon emitters with silicon-germanium bases) overcome the all-silicon bipolar transistor limitation on base doping levels due to carrier injection into the emitter.

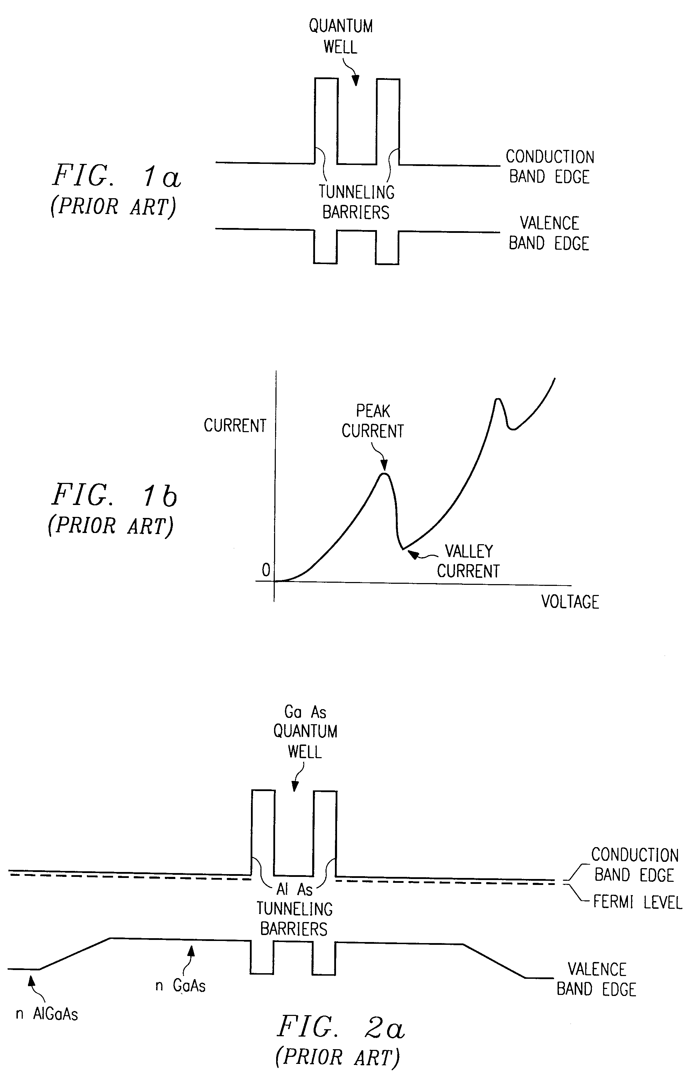

Scaling down device sizes to enhance high frequency performance leads to other quantum mechanical effects such as carrier tunneling through potential barriers. This led to development of device structures such as resonant tunneling diodes and resonant tunneling hot electron transistors which take advantage of such tunneling phenomena. Resonant tunneling diodes are two terminal devices with conduction carriers tunneling through potential barriers with energy resonance yielding current-voltage curves having portions exhibiting negative differential resistance. Recall that the Esaki diode had interband tunneling (e.g., from conduction band to valence band) in a heavily doped PN junction diode. More recent versions of interband tunneling resonant tunneling diodes include combinations of materials such as in Luo et al., Interband Tunneling in Polytype GaSb/A1Sb/InAs Heterostructures, 55 Appl.Phys.Lett. 2023 (1989). An alternative resonant tunneling diode structure relies on resonant tunneling through a quantum well in a single band. For example, Mars et al., Reproducible Growth and Application of AlAs/GaAs Double Barrier Resonant Tunneling Diodes, 11 J.Vac.Sci.Tech.B 965 (1993), and Özbay et al, 110-GHz Monolithic Resonant-Tunneling-Diode Trigger Circuit, 12 IEEE Elec.Dev.Lett. 480 (1991), each use two AlAs tunneling barriers imbedded in a GaAs structure to form a quantum well resonant tunneling diode. The quantum well may be 4.5 nm thick with 1.7 nm thick tunneling barriers. Figure 1a shows a band diagram for a quantum well resonant tunneling diode, and Figure 1b illustrates current-voltage behavior at room temperature.

Optical interconnections for electronic circuits or systems typically have transmitters such as lasers and light signal detectors such as photoconductors or photodiodes. However, photoconductors and photodiodes typically absorb a large portion of input irradiance, which limits fanout, and the output electrical current depends upon input irradiance, which then requires a 1-bit output analog-to-digital converter to be used in a digital system.

Chemla et al., U.S. Patent No. 5,047,810, control the operation of a double barrier quantum well resonant tunneling diode with light impinging on the quantum well and having photon energy less than the bandgap of the quantum well material. The pulsed incident light (at about 10⁹ watts/cm) induces a virtual electron-hole pair population within the quantum well which slightly increases (5-30 meV) the resonant energy level of the quantum well via the AC Stark effect. This increase in eigenstate energy increases the apparent bias of the diode at which resonance occurs. In other words, impinging light shifts the valley of the current-voltage curve of Figure 1b to the right. The amount of valley shift depends upon both the intensity of the impinging light and the photon energy. This has problems including a high light power density required for operation.

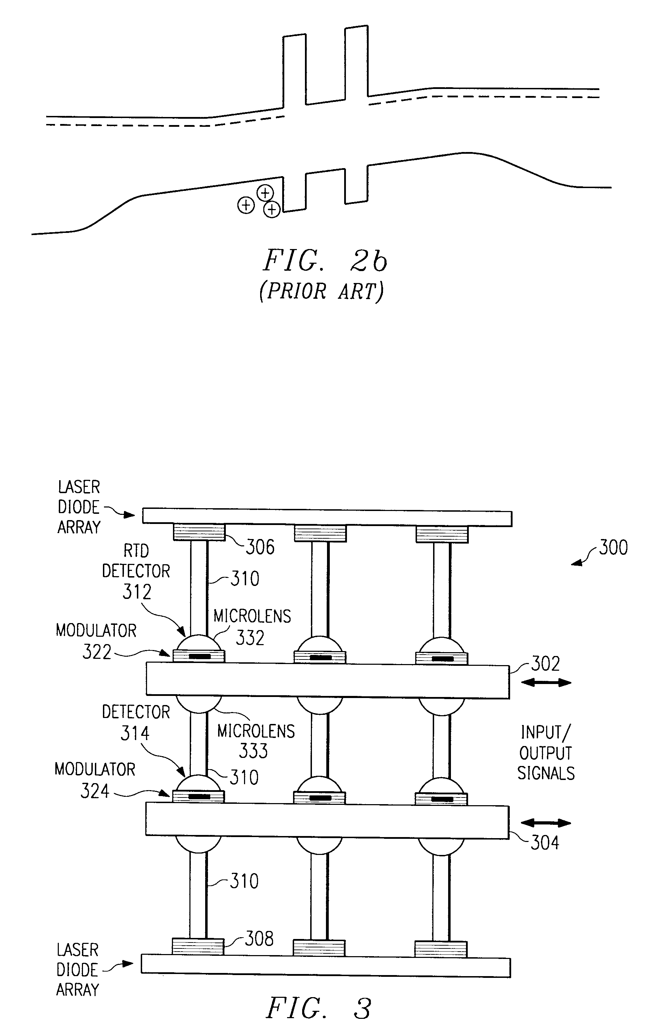

England et al., U.S. Patent No. 6,126,553, and England et al., Optical Switching in a Resonant Tunneling Structure, 58 Appl.Phys.Lett. 887 (1991), demonstrate a bistable optical switch with an input light pulse changing the state of a quantum well resonant tunneling diode (with two stable current-voltage states in the dark) which in turn changes the opacity or other optical property of the diode. Input photons have energy greater than or equal to the quantum well bandgap energy, and Figure 2a shows the band diagram. The quantum well uses n-type GaAs anode and cathode with AlAs tunneling barriers and n-type transparent AlGaAs anode and cathode contacts. Thus a pulse of photons (at about 10⁴ watts/cm) with energy between the bandgap energies of the AlGaAs and the GaAs may be absorbed exclusively in the GaAs and give rise to photogenerated electron-hole pairs in that layer. With the diode biased, the pulse of photogenerated holes will accumulate at the tunneling barrier (illustrated in Figure 2b) and will locally enhance the electric field at the quantum well; this pushes the diode to an unstable operating point and allows the diode to switch to its other stable dark operating point. Thus an input light pulse essentially provides a trigger to switch the electrically-bistable-in-the-dark device which also shows different optical properties in its two stable dark states. Hence, this also provides switching for optical outputs.

Koyanagi et al, Design of 4-kbit x 4-Layer Optically Coupled Three-Dimensional Common Memory for Parallel Processor System, 25 IEEE J.Sol.St.Cir. 109 (1990), show a parallel processor system with each processor having a corresponding memory made of rows and columns of SRAM cells; and the SRAM cells are also connected optically in the third dimension. That is, a cell's bit may be written to the corresponding cell in an adjacent processor's memory. This optical memory connection uses LED emitters in the writing cell and phtoconductive load resistors in the written-to cell. Each processor's memory is on a (thinned) silicon wafer (with GaAs grown on the silicon for the LED and photoconductor structures), and the wafers covered with glass and vertically stacked and bonded together.

Wu and Barnes (editors), Microlenses, Coupling Light to Optical Fibers (IEEE Press 1991) reprints various articles which consider the fabrication of microlenses such as could be used for coupling laser diodes to optical fibers. In particular, pages 301-304 describe the melting of photoresist cylinders into arrays of microlenses with lens diameters about 30 mm. Similarly, Mihailov and Lazare, Fabrication of Refractive Microlens Arrays by Excimer Laser Ablation of Amorphous Teflon, 32 Appl. Optics 6211 (1993) describe fabrication of microlenses by excimer laser patterning a layer of amorphous teflon into short cylinders followed by melting the teflon to allow surface tension to pull the teflon into spherical lenses. Amorphous teflon is transparent and not opaque as the common semicrystalline teflon. The microlenses are on the order of 100 mm in size. The amorphous teflon is a copolymer of tetrafluoroethylene and 2,2-bis(trifluoromethyl)-4,5-difluoro-1,3-dioxolane.

### SUMMARY OF THE INVENTION

The present invention provides transparent optical detectors and optical interconnect systems using transparent detectors and photomodulators. Preferred embodiment detectors include light absorbing layers which generate a screening electric dipole layer to adjust a resonant tunneling current and yield a digital electrical output. Either resonant tunneling diodes or resonant tunneling transistors may be optically driven in this manner.

This optical interconnect system has advantages including a low component count, reconfigurability, and high fanout optical connections. The transparent detector has advantages including high sensitivity, digital electrical output, and a low absorbance of input light to permit the high fanout.

According to one aspect of the present invention there is provided a transparent photodetector, comprising a resonant tunneling diode including a quantum well between first and second tunneling barriers, the absorbance of said diode being less than about 10% of incident light of a frequency to be detected; a load impedance in series with said diode, said impedance characterized by said diode having (1) a single first stable current-voltage point when (i) a bias voltage is applied across said diode plus impedance in series and (ii) incident light to said diode has an irradiance less than a threshold and (2) a single second stable current-voltage point differing from said first stable current-voltage point when (i) said bias voltage is applied across said diode plus impedance in series and (ii) incident light to said diode has an irradiance greater than said threshold; and an electrical output between said diode and said impedance.

According to a second aspect of the present invention there is provided a transparent photodetector, comprising a transparent emitter and a transparent collector; first and second transparent tunneling barriers, said tunneling barriers between said emitter and collector; a quantum well between said first and second tunneling barriers; and a transparent light absorbing region adjacent said first tunneling barrier, said region characterized by absorption of at most 10% of incident light at said frequency to be detected; whereby absorption of light in said absorbing region affects resonant tunneling of carriers through said tunneling barriers and quantum well.

According to a third aspect of the present invention there is provided a method of photodetection, comprising the steps of providing a transparent resonant tunneling diode providing a load impedance in series with said diode; applying a bias across said diode and impedance in series; and detecting a voltage drop across said impedance; wherein, said bias and impedance are characaterized by said diode having (1) a single first stable current-voltage point when incident light to said diode has an irradiance less than a threshold and (2) a single second stable current-voltage point differing from said first stable current-voltage point when incident light to said diode has an irradiance greater than said threshold.

According to a fourth aspect of the present invention there is provided an optical interconnection system, comprising transparent detectors D1, D2, ... Dn with n a positive integer greater than one; optical emitters E1, E2, ... Em with m a positive integer; and a plurality of optical links connecting said D1, D2, .... Dn and said E1, E2, ... Em in series.

According to a fifth aspect of the present invention there is provided a method of optical communication, comprising the steps providing an optical emitter; providing a plurality of transparent detectors; and providing a plurality of optical links to connect said detectors in series to said optical emitter.

### BRIEF DESCRIPTION OF THE DRAWINGS

The drawings are schematic for clarity. Figures 1a-b are a band diagram and a current-voltage curve for a known resonant tunneling diode.

Figures 2a-b are band diagrams for a known photosensitive resonant tunneling diode with bias.

Figure 3 illustrates a first preferred embodiment optical interconnection system.

Figure 4 is a band diagram for a first preferred embodiment photosensitive resonant tunneling diode.

Figure 5 shows the current-voltage curves for a first preferred embodiment photosensitive detector.

Figure 6 is the band diagram of Figure 4 with applied bias and illustrating optical switching.

Figure 7 illustrates the optical noise margin of the first preferred embodiment detector.

Figure 8 shows in cross sectional elevation view a first preferred embodiment combination photosensitive detector and optical modulator.

Figure 9 is a schematic diagram for the combination of Figure 8.

Figure 10 is a cross sectional elevation view of a preferred embodiment optically-switched resonant tunneling diode.

Figures 11a-c show the current-voltage curves and a circuit plus timing diagram for another preferred embodiment optically-switched resonant tunneling diode.

Figures 12a-f show a cross sectional elevation view, band diagram, current-voltage curves, photosensitivity, and switching characteristics for a further preferred embodiment optically-switched resonant tunneling diode.

Figures 13a-b illustrates printed wiring board stacking in a preferred embodiment optical communication system.

Figures 14a-b show in cross sectional elevational view a preferred embodiment optically-triggered resonantly tunneling transistor and its band diagram.

Figure 15 illustrates switching for the embodiment of Figure 14a.

Figures 16a-b show circuit connections including the embodiment of Figure 14a.

Figure 17 illustrates another preferred embodiment optical communication system.

Figure 18 shows a reconfigurable optical-to-electrical switch.

Figures 19a-c show steps in a preferred embodiment method of fabrication.

Figure 20 illustrates a multiple-valued optical signal detector.

### DESCRIPTION OF THE PREFERRED EMBODIMENTS

### Overview of preferred embodiments

Figure 3 shows a first preferred embodiment optical communication system 300 for interconnecting digital electronic circuitry on separate printed wiring boards (PWBs) 302 and 304. System 300 includes optical links 310, transparent photosensitive detectors 312 and 314, optical modulators 322 and 324, and two laser diode transmitters arrays with laser diodes 306 and 308 at the ends of a serial stack of detectors, modulators, and links. For clarity Figure 3 does not show the electronic circuitry on PWBs 302 and 304, and only has reference numerals for a single serial stack of lasers, links, detectors, and modulators but illustrates two additional serial stacks which operate in parallel and in the same manner. This provides for parallel communication. Also, system 300 only has two PWBs, but more PWBs with more detectors and modulators could be added to increase the depth of the stack of PWBs and thus the number of detectors, modulators and links in the serial stacks.

System 300 operates as follows. Laser diodes 306 and 308 continuously emit at a wavelength of 830 nm along the abutting links 310. Optical links 310 may be optical fibers or free space with microlenses for collimating the light between PWBs; see microlenses 332-333 about detector 312 and modulator 322 in Figure 3. Modulators 322 and 324 either pass or block any incident light (from either direction) as controlled by digital electrical signals from the circuitry on the corresponding PWB. When the irradiance (light intensity) at detector 312 or 314 (summed from both abutting links) exceeds an irradiance threshold, the detector outputs a digital electrical high to the circuitry on the corresponding PWB; otherwise the output is a digital electrical low. The irradiance threshold is greater than the irradiance from a single diode but less than the irradiance from two diodes. Thus when the circuitry on PWB 302 drives modulator 322 into a blocking state, the irradiance at detector 314 is only the output of diode 308 (modulator 324 is in the pass state for detector 314 to be receiving signals), and detector 314 outputs a low to the circuitry on PWB 304. Conversely, when the circuitry of PWB 302 switches modulator 322 into a pass state, the irradiance at detector 314 then switches to the sum of the outputs of diodes 306 and 308 and exceeds the threshold, so detector 314 outputs a high. Thus serial communication between digital circuitry on PWB 302 and digital circuitry on PWB 304 can take place by output to modulators 322 and 324 and input from detectors 312 and 314. The parallel unnumbered serial stacks in Figure 3 have similar operation and the serial stacks together provide for parallel communication between the PWBs.

Detectors 312 and 314 are transparent in that they only absorb a few percent (typically 2-3%, but no more than about 10%) of the optical signal along optical links 310, so the optical pulse streams on optical links 310 may be fanned out to many detectors in deep stacks. An explicit fanout computation for 90% transmission efficiency for a detector plus optical link appears in the following Fanout section. Any type of transparent detector could be used, such as phototransistors modified for low absorption and with a backside opening for optical throughput. Of course, the transparency need only be for light of the frequency used. Putting a quantum well absorber in the optically active region of a phototransistor can provide the desired low absorption. Also, for very deep stacks some PWBs may have repeater lasers to maintain the optical power level. That is, for a serial stack a PWB may have two lasers with the optical signal coming from above driving one laser to emit downwards and with the optical signal coming from below driving the other laser to emit upwards.

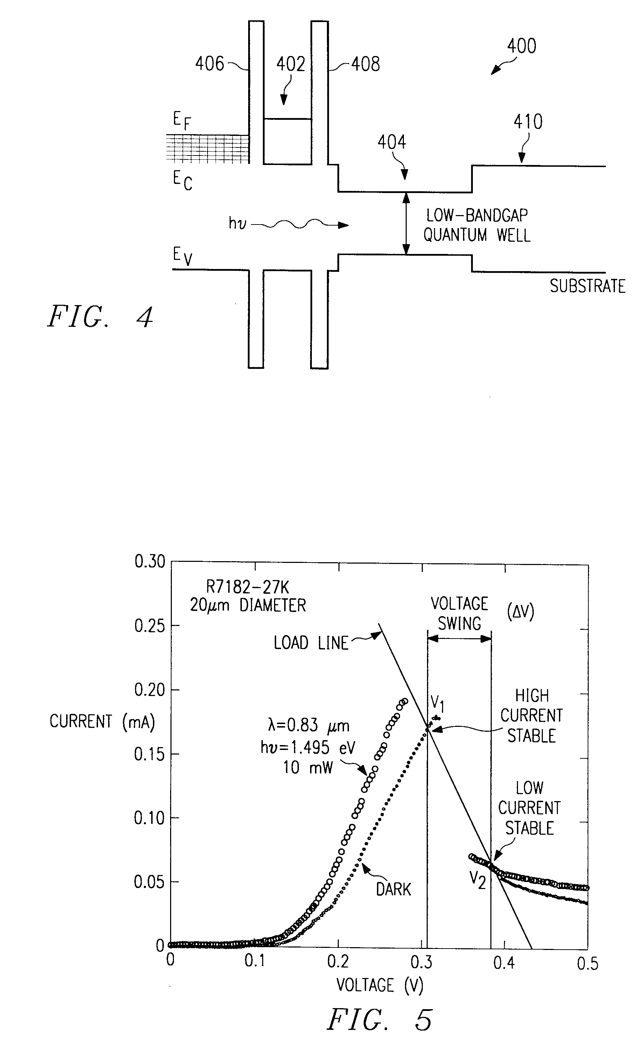

Each of detectors 312 and 314 may be an optically-switched resonant-tunneling diode (ORTD) or an optically-triggered resonant-tunneling transistor (ORTT) in series with a load circuit. The ORTD consists basically of a planar semiconductor resonant tunneling diode plus adjacent light absorbing quantum well. Figure 4 shows the conduction and valence band edges of ORTD 400 at flatband with the undoped region 410 in the righthand portion constituting part of a series resistor load for the diode. In particular, ORTD 400 includes double barriers 406-408 enclosing quantum well 402 with adjacent absorber quantum well 404. The double barrier-quantum well 402 forms a resonant tunneling diode with a current-voltage curve analogous to that of Figure 1b. The load resistor may be separated from the diode.

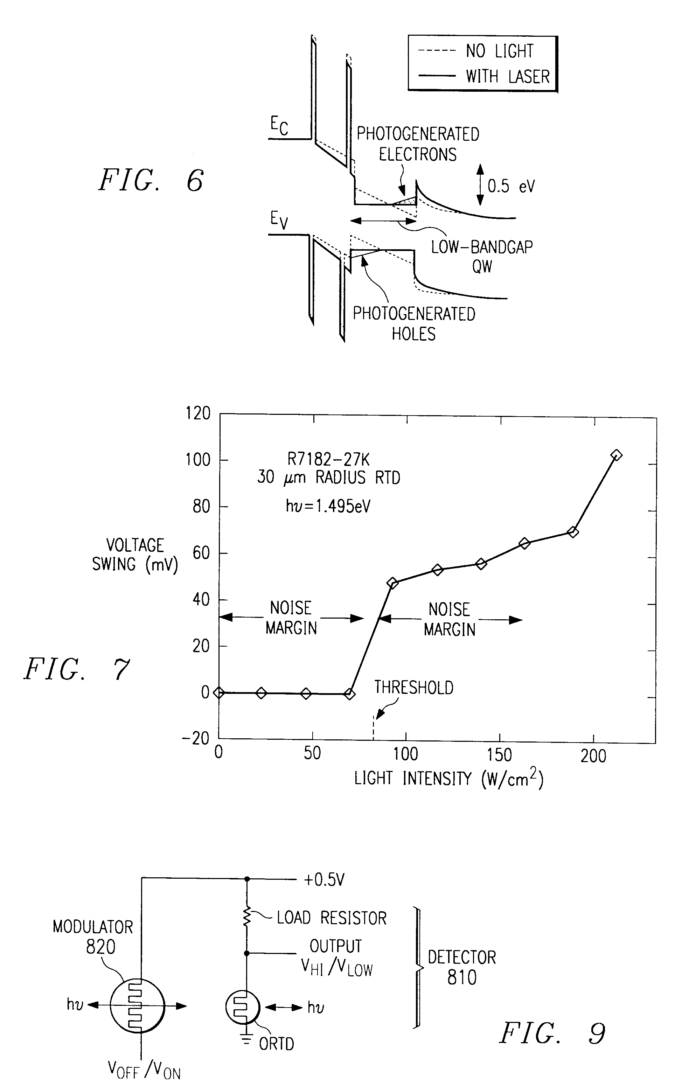

The ORTD operates as follows. Apply a bias voltage across the ORTD plus series load: with no input light, a single, high-current stable operating point exists as illustrated by the solid circle curve in Figure 5. The portion of this applied bias across the diode tilts the conduction and valence band edges as illustrated by the solid lines in Figure 6, and this is near the maximum resonance electron current through the double barrier quantum well 402. The transmitted electrons ballistically traverse absorber quantum well 404.

When light impinges on the diode, photons with energy just greater than the bandgap energy of quantum well 404 will be absorbed in quantum well 404 and create electron-hole pairs which separate due to the electric field (conduction and valence band edge tilt). These separated positive and negative charges develop a local electric field counter to the field of the bias; Figure 6 illustrates this with dotted line changes in the band diagram and the heuristic circled + and - charges. The local field in quantum well 404 thus effectively increases the electric field across the double barriers plus quantum well 402 which will push the energy levels out of resonance. Graphically, this amounts to shifting the diode current-voltage curve to the left in Figure 5 as shown by the open-circle curve. Thus the resonant current drops and the electric field across quantum well 402 further increases as the voltage drop across the resistor decreases. A single low-current stable operating point now exists and the ORTD switches to this operating point illustrated in Figure 5. Once the input light ceases, no further electron-hole pairs are generated, and the existing electron-hole pairs recombine to extinguish the local electric field. The ORTD then switches back to the high-current stable operating point.

The ORTT is somewhat analogous to an ORTD with gain, and the ORTT section in the following gives a detailed description.

Detectors 312-314 digitally detect input light signals; Figure 7 shows the transfer function. Note that the noise margins arise due to the electron-hole pair generation rate depending roughly linearly upon the input irradiance while the switch function has a digital nature.

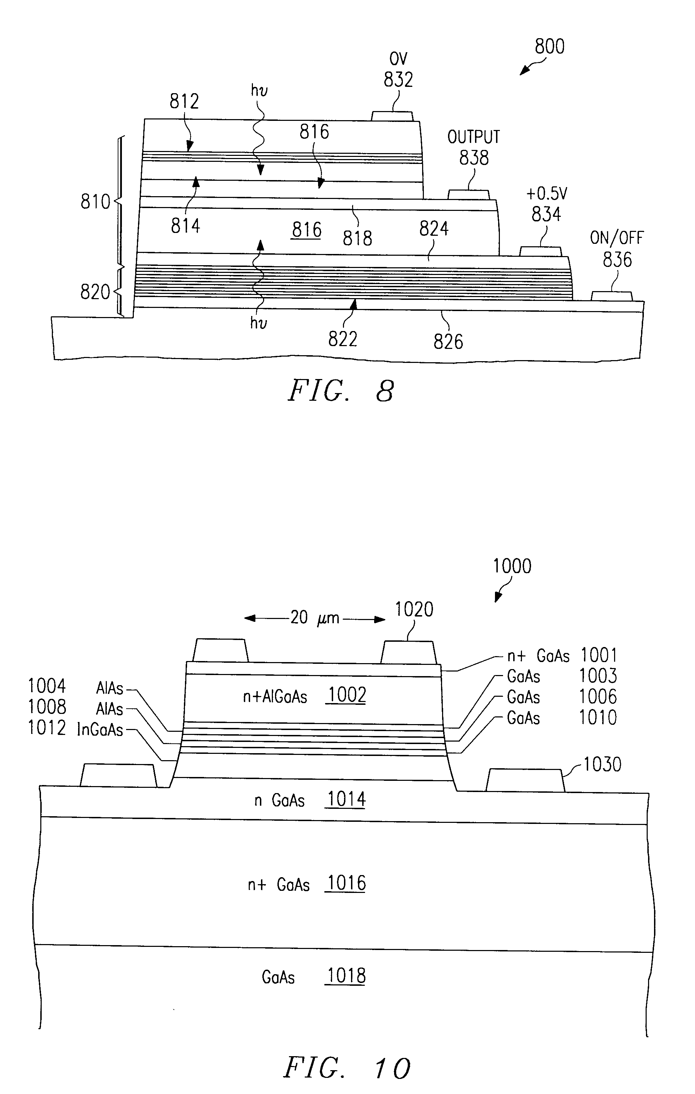

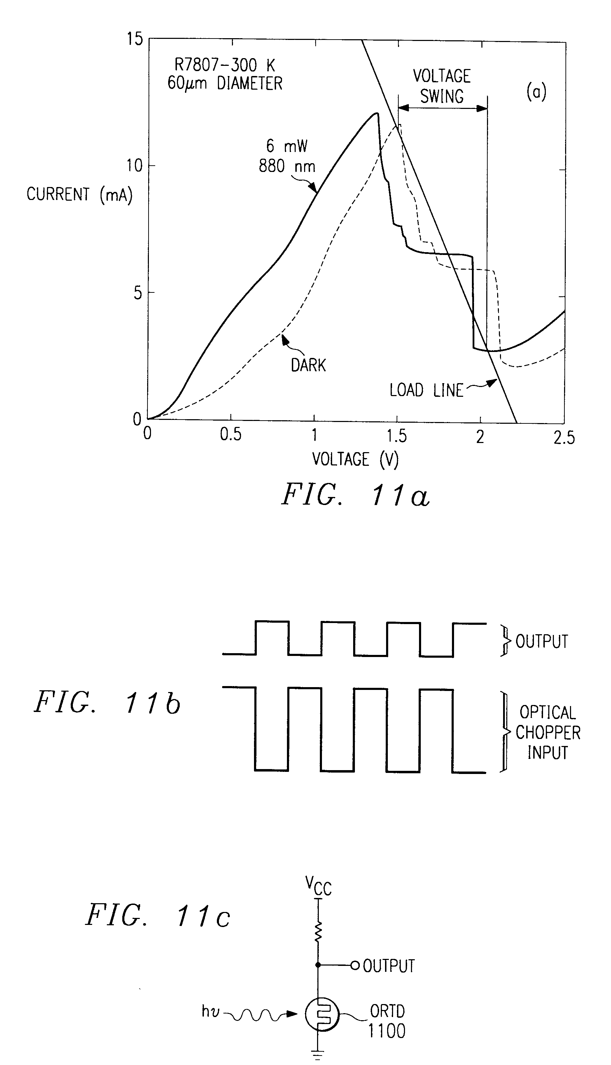

Modulators 322 and 324 may be multiple quantum well modulators which employ the quantum confined Stark effect to have electrical control of optical transmittance. Figure 8 heuristically illustrates detector 810 on modulator 820 with a mesa structure. Detector 810 includes double barrier plus quantum well 812, absorber quantum well 814, resistor 816 with a doped layer 818 for output contact 838. Modulator 820 includes multiple (perhaps 50) quantum wells 822 with doped contact layers 824 and 826. Detector 810 has a constant bias through contacts 823-834, and modulator 820 is switched on-off by bias through contacts 834-836. The light traverses the structure as indicated by the wavy arrows. Figure 9 schematically shows the detector-modulator structure with modulator 820 controlled by a digital voltage (V_{OFF}/V_{ON}) supplied by the circuitry on the PWB, and detector 810 with a constant bias but a digital output voltage (V_{HIGH}/V_{LOW}).

### Optically-switched resonant-tunneling diode (ORTD)

Figure 10 shows in cross sectional elevation view preferred embodiment ORTD 1000 which operates at 27 K. ORTD 1000 has a mesa form similar to ORTD 810 and includes the epitaxial layers as listed in following Table I on a GaAs substrate. Note that InGaAs denotes In_{0.05}Ga_{0.95}As and AlGaAs denotes Al_{0.3}Ga_{0.7}As.

**Table I**

| Layer | Material | Thickness | Doping level (x10¹⁸/cm³) |
|---|---|---|---|
| Contact | n+ GaAs | 10 nm | 5 |
| Emitter | AlGaAs | 200 nm | 1 |
| Spacer | GaAs | 2 nm | undoped |
| Barrier | AlAs | 3 nm | undoped |
| Well | GaAs | 2 nm | undoped |
| Barrier | AlAs | 3 nm | undoped |
| Spacer | GaAs | 2 nm | undoped |
| Absorber well | InGaAs | 25 nm | undoped |
| Collector | n GaAs | 40 nm | 0.2 |
| Subcollector | n+ GaAs | 800 nm | 5 |
| Spacer | GaAs | 2 nm | undoped |

Emitter (cathode) metal contacts 1020 and collector (anode) metal contacts 1030 may be annular and made of Ti/Pt/Au (successive layers of titanium, platinum, and gold) of thickness 300 nm. The 20 mm diameter inside opening of emitter contact 1020 provides topside optical access, and substrate 1018 provides the bottomside optical access.

At a temperature of 27 K the bandgap energy of GaAs (top contact 1001, spacer 1003, tunneling quantum well 1006, spacer 1010, collector 1014, subcollector 1016, and substrate 1018) is about 1.513 eV, whereas the bandgap energy of InGaAs (absorber quantum well 1012) is about 1.485 eV. Consequently, photons with energies of about 1.495 eV (near infrared light with wavelength about 830 nm) may be absorbed in absorber quantum well 1012 but not by any of the other layers in the ORTD structure. Experimentally, about 1-2 percent of a normally incident photon flux at this energy is absorbed in absorber quantum well 1012. Figure 5 shows the current-voltage characteristics.

Figure 6 is the band diagram of ORTD 1000 with a bias of about 0.43 volt from bias contact to emitter: the solid lines show the band edges with no incident light and the broken lines the band edges with an incident power density of 17 watts/cm. The recombination rate for photogenerated electrons and holes depends upon the wavefunction overlap which decreases with increasing electric field across quantum well 1012 and increases with increasing photogenerated carrier density. A generation-recombination steady state will be reached within about a picosecond of illumination due to the fast nature of the processes. In particular, at the high-current operating point (a voltage drop of about 100 mV across quantum well 1012 to establish tunneling resonance), incident light at 1.495 eV will photo-generate a steady state of electron-hole pairs which will increase the voltage across the double barrier (1004, 1008) tunneling quantum well (1006) by about 20 mV, which is the threshold for disruption of the resonant tunneling current. The drop in resonant current has a positive feedback of further increasing the voltage drop across quantum well 402 to about 150 mV and makes the switching to the low-current operating state rapid. A somewhat smaller incident photon flux will not photo-generate enough charge in quantum well 1012 to disrupt resonant tunneling, and the high-current operating state persists. Thus the sharp current transition illustrated in Figure 7 as a function incident photon flux.

### Room temperature ORTD

Figure 11a shows the room-temperature current-voltage characteristics of ORTD 1100 with structure and operation similar to that of ORTD 1000 but made of the following materials: a 250-nm thick n+ InAlAs emitter (cathode), AlAs/InGaAs/AlAs double tunneling barrier and quantum well, and a 100-nm thick InGaAs absorber layer (with InGaAs denoting In_{0.53}Ga_{0.47}As). Photons with energy above 0.8 eV are absorbed in the absorber layer and generate electron-hole pairs which separate under bias and providing a screening (counter) electric field to reduce the diode voltages for the peak and valley currents. The current-voltage characteristics of Figure 11a are for a 60-mm diameter diode and show a 200 mV reduction of voltage for the peak and valley currents when illuminated with 1.4 eV photons (880 nm wavelength) at 200 watts/cm. When biased at 2.15 volts through a 53 ohm resistor, the output voltage swing is about 500 mV: with no illumination in the high current state the diode voltage drop is about 1.5 volts, and with illumination in the low current state the diode voltage drop is about 2.0 volts.

Figure 11b shows the response of the circuit of Figure 11c incorporating ORTD 1100 when the input light is chopped pursuant to the signal of the lower trace of Figure 11b. The upper trace of Figure 11b shows the resulting output voltage.

### Second room temperature ORTD

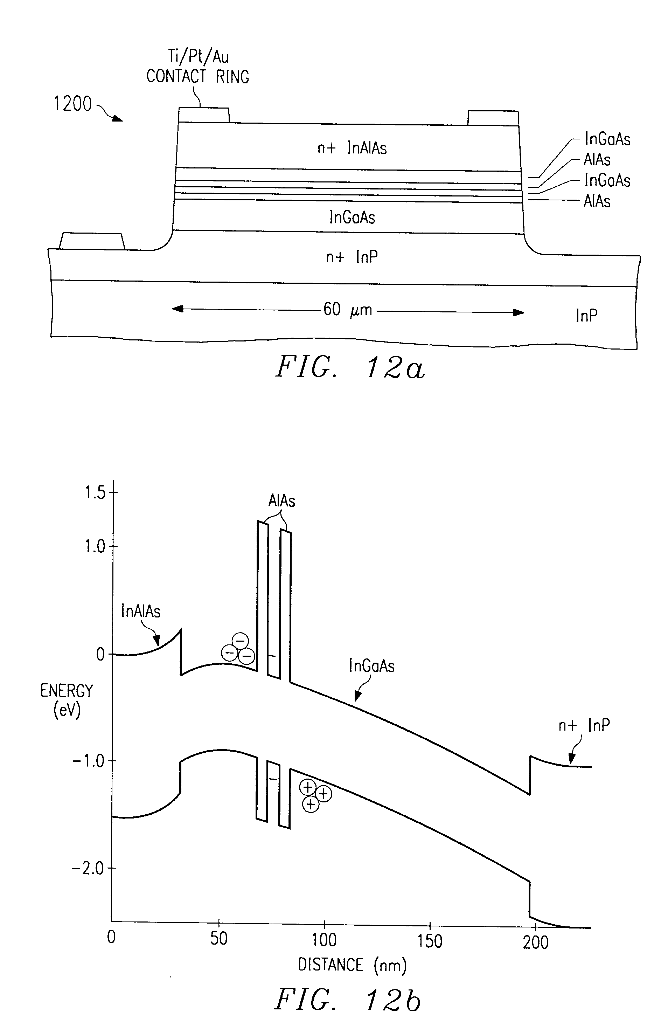

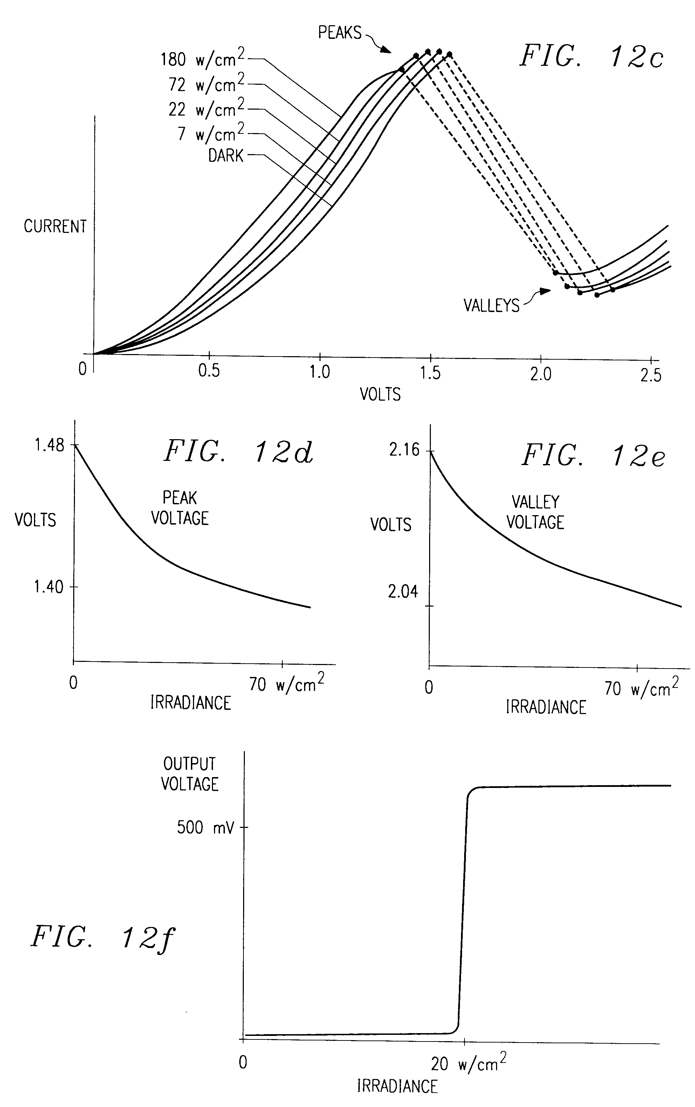

Figure 12a shows a second room-temperature resonant tunneling diode 1200 in cross sectional elevation view and Figure 12b shows the corresponding conduction and valence band diagram. Diode 1200 has a simple structure: 100 nm of undoped InGaAs between an n+ InP buffer electrical contact on an InP substrate and an n+ InAlAs top window electrical contact with a pair of AlAs tunneling barriers forming a quantum well in the InGaAs about 40 nm from the InAlAs top window. Diode 1200 has a mesa shape with a diameter of 60 mm. The InP and InAlAs have bandgaps of about 1.4 eV, whereas the InGaAs has a bandgap of about 0.8 eV. Hence, photons with energies in the range of 0.8 to 1.4 eV will pass through the top window and buffer but will be absorbed in the InGaAs. This corresponds to photons with free space wavelengths of 880 nm to 1.55 mm. Photons with energies slightly above the bandgap of the InP and/or the InAlAs will be much less strongly absorbed than by the InGaAs due to the lower density of states near the band edges, and such frequencies could be used provided the overall transparency of the detector does not fall too much.

A bias of the n+ buffer 1.1 volts with respect to the n+ top window yields the band bending as illustrated in Figure 12b. As with ORTDs 1000 and 1100, photons absorbed by the InGaAs creates electron hole pairs which the applied bias separates; holes accumulate on the buffer side of the tunneling barriers and electrons accumulate on the top window side. These accumulated charges increase the electric field across the tunneling barriers and quantum well; thus the current resonance occurs at a lower applied bias than with no photon absorption and accumulated charges. Figure 12b heuristically indicates the accumulated holes as circled +s and the accumulated electrons as circled -s.

Figure 12c shows the current-voltage curves of diode 1200 for five irradiance (optical power) levels with a 860 nm laser. The location of the peak and valley voltages with no illumination can be varied by varying the thickness of the InGaAs layer. Indeed, with a thin InGaAs layer (10 nm) the peak and valley voltages will be about 0.65 and 0.9 volts, respectively; whereas, with a thick InGaAs layer (200 nm) the peak and valley voltages increase to about 3.1 and 3.8 volts, respectively. The diode current-voltage measurement circuit essentially determines the current between the peak and the valley, so Figure 12c only shows a broken line connecting the peaks and the valleys.

As with ORTDs 1000 and 1100, increasing the optical power impinging on ORTD 1200 decreases both the peak voltage and the valley voltage. Figure 12d shows the dependence of peak voltage on irradiance, and Figure 12e the valley voltage dependence. This voltage-irradiance dependence applies for various wavelength illumination: 860 nm, 900 nm, and 1300 nm all give similar results.

ORTD 1200 with a load resistor (see Figure 11a discussion) has shown an output voltage swing of about 0.6 volt for irradiance changes about a threshold on the order of 20 watts/cm for 1300 nm input. Figure 12f shows the measured room-temperature thresholding characteristics.

### Fanout

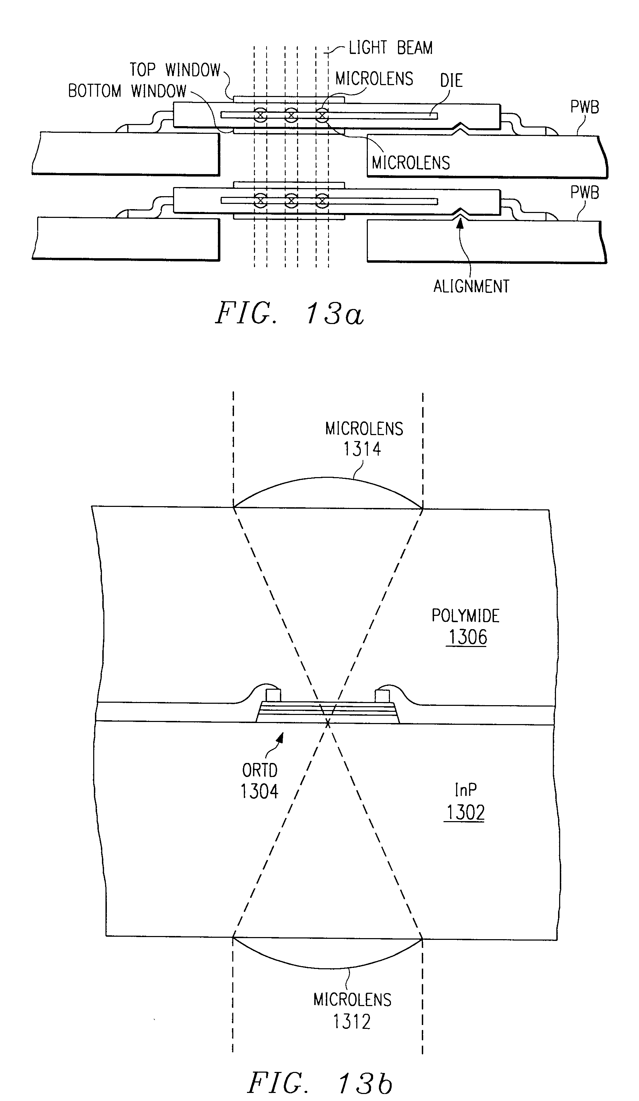

The first embodiment system 300 may include many PWBs, depending upon the transmission efficiencies in the detectors and modulators. For PWBs closely stacked (low profile chips with PWBs about 10 mm apart), free space optical links may be used by providing microlenses on both the top and bottom of the semiconductor dice containing the detectors-modulators plus top and bottom windows in the chip packages; see Figure 13a which shows a cross sectional elevation view of two PWBs with three parallel optical channels. The PWBs and the ORTD chip packages could have alignment ridges and cavities as illustrated or could be mounted on the PWBs with alignment screws for adjustment after mounting. The microlenses and windows would have antireflective coatings and the microlenses would colliminate or focus the light. In particular, Figure 13b is an enlargement illustrating InP substrate 1302 of thickness 500 mm with ORTD 1304 formed on its top surface and backside microlens 1312 plus deposited oxide 1306 of thickness 500 mm on ORTD 1304 and microlens 1314 on oxide 1306. Oxide 1306 provides spacing so the two microlenses may have the same pupil diameter, focal length, and numerical aperture. Microlenses 1312-1314 each has a focal length of about 500 mm so parallel light rays between chips are focussed on the active region of ORTD 1304 and collected and recollimated for transmission to the adjacent PWB. Each microlens has a diameter of about 300 mm and a numerical aperture of roughly 0.3.

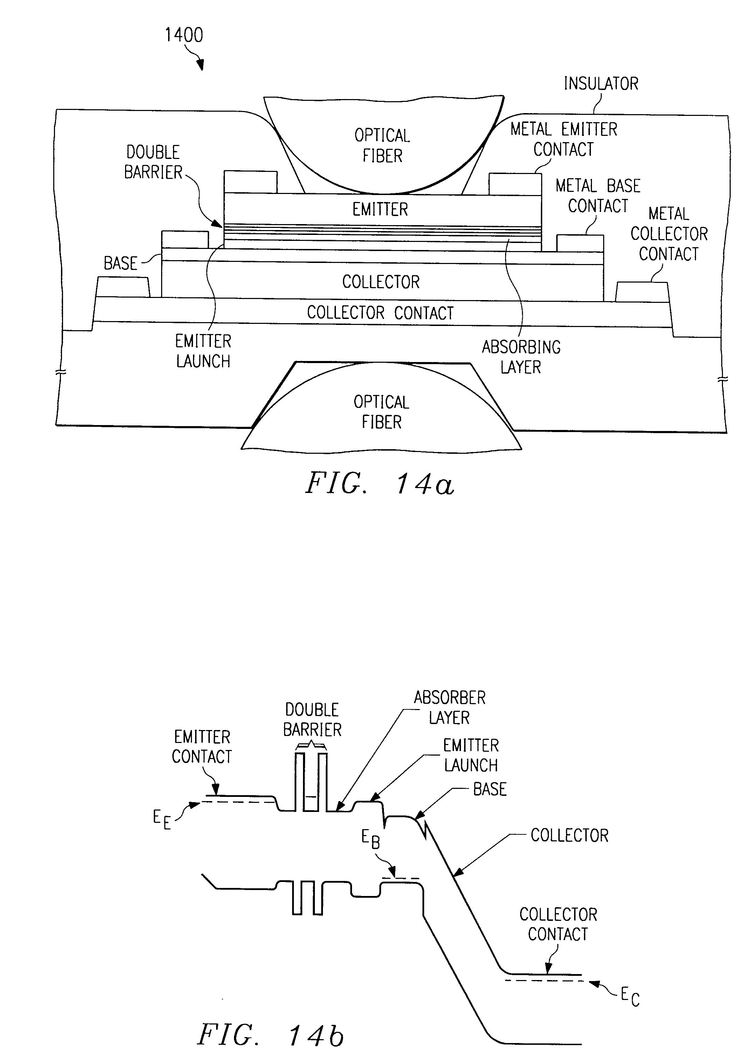

Alternatively, optical fibers may be butt coupled to the detectors-modulators, and the PWBs can then be located arbitrarily. See Figure 14a showing a cavity etched in the backside of the substrate for optical fiber alignment.

As an example, consider a 90% transmission efficiency (10% loss and ignore reflections) for each detector/modulator pair. Then with ten PWBs, the irradiance at the detector, as a percent of a single diode emission, for each PWB is shown in the righthand three columns of the following table for the cases of (1) none of the modulators blocking, (2) only the modulator of the first PWB blocking, and (3) only the modulator of the fifth PWB blocking:

| PWB | %top | %bottm | no block | #1 block | #5 block |
|---|---|---|---|---|---|
| 1 | 100 | 39 | 139 | block | 100 |
| 2 | 90 | 43 | 133 | 43 | 90 |
| 3 | 81 | 48 | 129 | 48 | 81 |
| 4 | 73 | 53 | 126 | 53 | 73 |
| 5 | 66 | 59 | 125 | 59 | block |
| 6 | 59 | 66 | 125 | 66 | 66 |
| 7 | 53 | 73 | 126 | 73 | 73 |
| 8 | 48 | 81 | 129 | 81 | 81 |
| 9 | 43 | 90 | 133 | 90 | 90 |
| 10 | 39 | 100 | 139 | 100 | 100 |

As is apparent, the maximum irradiance at a detector with at least one modulator in a different PWB blocking is 100% of a single diode emission; whereas, with no blocking modulators the minimum irradiance at a detector is 125% of a single diode. Thus take the threshold between 100% and 125% of a single diode emission. Of course, with a higher transmission efficiency, the minimum for no modulators blocking will increase, but the maximum with at least one blocking will remain the same. Analogously, with fewer PWBs the minimum will increase without the maximum increasing, and with more PWBs the minimum will decrease.

An alternative to two laser diode arrays 306, 308 would be a single laser diode array 306 and an array of mirrors in place of array 308. Again, the threshold need only be above 100%. Indeed, for five PWBs and again 90% transmission the corresponding intensities are:

| PWB | % top | % reflect | no block | #1 block | #5 block |
|---|---|---|---|---|---|
| 1 | 100 | 39 | 139 | block | 100 |
| 2 | 90 | 43 | 133 | 0 | 90 |
| 3 | 81 | 48 | 129 | 0 | 81 |
| 4 | 73 | 53 | 126 | 0 | 73 |
| 5 | 66 | 59 | 125 | 0 | block |

Again, a threshold of between 100% and 125% of the incident laser power will suffice. The transparency of the detectors permits the high fanout.

### Fabrication

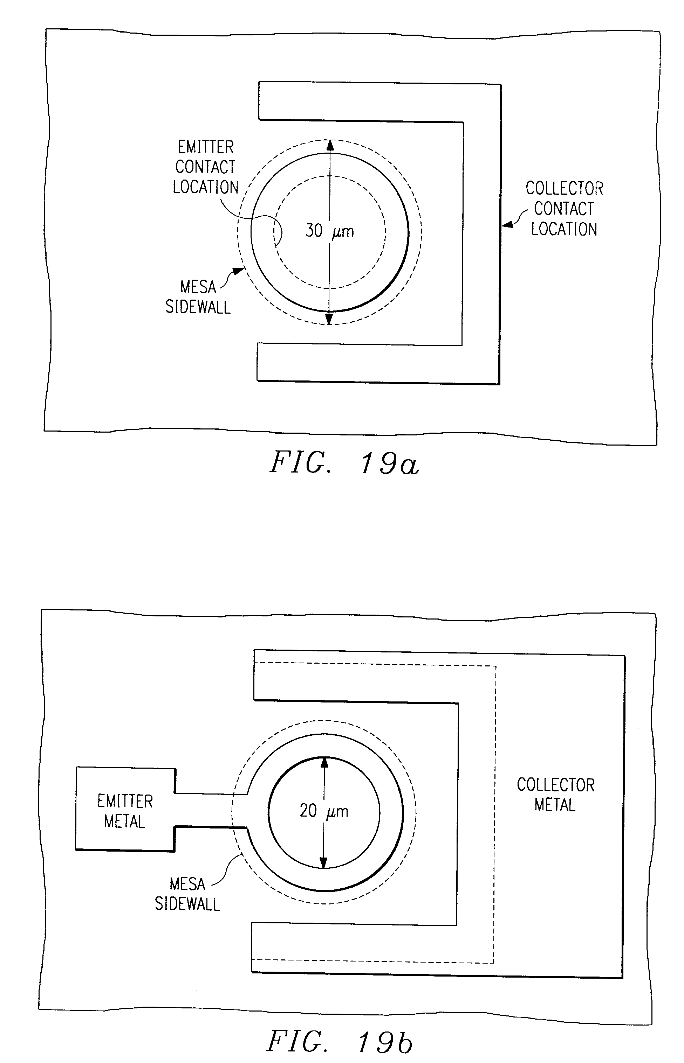

Preferred embodiment ORTD detector 1000 may be fabricated with a process including the following steps.
(1) Begin with a 25-mil thick (100)-oriented semi-insulating GaAs wafer. Epitaxially grow by metalorganic molecular beam epitaxy (MOMBE) or metalorganic chemical vapor deposition (MOCVD) the layers listed in Table I. Elemental Ga, In, and Al sources provide the group-III species, and tertiarybutylarsine provide the group-V species after cracking. Elemental tin provides the n type doping.
(2) Spin on photoresist and pattern it to define the location of the mesa, which has a diameter of 30 mm. Next, perform a timed etch with a solution of sulfuric acid plus hydrogen peroxide to form the mesa. This etch through the emitter, double barrier, and absorber quantum well layers only removes about 0.25 mm of material, so the isotropic nature of the wet etch does not present a problem of lateral encroachment and the mesa does not pose step coverage problems. Then strip the photoresist.
(3) Deposit a 0.2 mm thick layer of silicon nitride which provides passivation and insulation. Spin on a second photoresist and pattern it to define the location of emitter contact 1020 plus interior (circular) and collector contact 1030 (horseshoe shaped). Then etch the silicon nitride with phosphoric acid using the patterned photoresist as etch mask, and strip the photoresist. See Figure 19a for a plan view.
(4) Form the emitter and collector contacts plus attached pad metal by liftoff of Ti/Pt/Au. (Liftoff consists of patterning photoresist, depositing metal, and dissolving the photoresist to liftoff the metal not deposited on either semiconductor or silicon nitride.) The total metal thickness is about 300 nm with most of the thickness the top layer of Au. If desired, further Au can be plated to thicken the metal. See Figure 19b for a plan view and Figure 19c for a cross sectional elevation view.
(5) Lastly, form air bridges or other interconnects to connect the contacts or pads with either other devices or bond pads on substrate 1018. Other devices such as MESFETs and HBTs could be fabricated in other portions of substrate 1018. Indeed, MESFETs may be directly formed in substrate 1018 by implantation of source, drain, and channel regions.

Further processing may be included to assist the optical link attachment. In particular, deposit 500 mm of a transparent insulator such as polyimide 1306 to provide the spacing for top microlens 1314 from ORTD 1304 as illustrated in Figure 13b. Backside microlens 1312 may be formed on substrate 1302 or may be formed in substrate 1312 by use of an anisotropic etch to transfer a microlens pattern made of photoresist into the substrate. Alternative substrate processing may assist the fixing of an end of an optical fiber link to both the substrate and the opening defined by the emitter contact. For example, etch a sloped-sidewall via (with minimum diameter to match the diameter of the desired optical fiber) in a dielectric (silicon dioxide or silicon nitride) layer deposited over the mesa and centered at the emitter contact opening. Similarly, etch sloped-sidewall vias in the backside of the substrate to both align an optical fiber and reduce the substrate thickness to lessen losses. Figure 14a shows the analogous structure for an ORTT to be described in the following.

In the case of microlenses, deposit a photoresist layer on the transparent insulator over the mesa and pattern the photoresist to leave a cylinder of photoresist over the mesa. Then heating will melt the photoresist cylinder and cause surface tension to pull the photoresist cylinder into a spherical microlens. Then deposit a similar film on the substrate backside and again pattern and melt to form backside microlenses. Alternatively, amorphous teflon could be used in place of the photoresist to form the mmicrolenses. In particular, deposit an amorphous teflon film and excimer laser ablate all of the film except over the mesa. Then heat to 300°C for 20 minutes to allow surface tension to form the spherical microlens. Repeat for the backside microlens.

An alternative would be to avoid using the transparent insulator over the mesa and put the microlens directly on the ORTD mesa. For microlenses directly on the mesa, a very short focal length should be needed, and this requires large curvature such as with a small diameter lens.

Further, the microlenses could be formed in the substrate and in the topside transparent insulator by an anisotropic etch which could transfer the photoresist or teflon microlens structure into the substrate and the transparent insulator.

### Optically-triggerred resonant-tunneling transistor (ORTT)

Figure 14a shows in cross sectional elevation view first preferred embodiment optically-triggered resonant tunneling transistor (ORTT) 1400 as including the epitaxial layers as listed in following Table II on an InP substrate.

Note that InGaAs denotes In_{0.53}Ga_{0.47}As and InAlGaAs denotes In_{0.52}Al_{0.3}Ga_{0.18}As.

**Table II**

| Layer | Material | Thickness | Doping level (x10¹⁸/cm³) |
|---|---|---|---|
| Emitter Contact | n+ InGaAs | 30 nm | 10 |
| Emitter | n+ InAlGaAs | 200 nm | 10 |
| Pre-diode | n+ InGaAs | 30 nm | 1 |
| Spacer | InGaAs | 2 nm | undoped |
| Barrier | AlAs | 2 nm | undoped |
| Tunneling well | InGaAs | 5 nm | undoped |
| Barrier | AlAs | 2 nm | undoped |
| Spacer | InGaAs | 2 nm | undoped |
| Absorber layer | InGaAs | 50-100 nm | undoped |
| Post-diode | n+ InGaAs | 30 nm | 1 |
| Launch | n+ InAlGaAs | 50 nm | 10 |
| Launch | n InAlGaAs | 50 nm | 0.5 |
| Base | p+ InGaAs | 100 nm | 1 |
| Collector | n InP | 2000 nm | 0.02 |
| Collector contact | n+ InP | 500 nm | 10 |
| Substrate | InP | 500 mm | semi-insulating |

As with ORTD 1000, the metal contacts (emitter, base, and collector) may be annular or horseshoe shaped and made of Ti/Pt/Au (successive layers of titanium, platinum, and gold) of total metal thickness about 300 nm. Air bridges may be used for interconnection to the metal contacts, or insulation may be deposited and interconnections connect to the contacts through etched vias.

Figure 14a also illustrates optical fibers in position both above and below the active area of ORTT 1400 with sloped wall vias in the substrate and in an overlying protective insulator layer. Such vias aid alignment and attachment of the optical fibers, which typically would have an outside diameter of roughly 10 mm for single mode operation or roughly 50 mm for multimode operation with infrared light. Alternatively, a microlens could be formed on the emitter or on the substrate backside or both, and the optical fibers aligned with but spaced from the microlens(es).

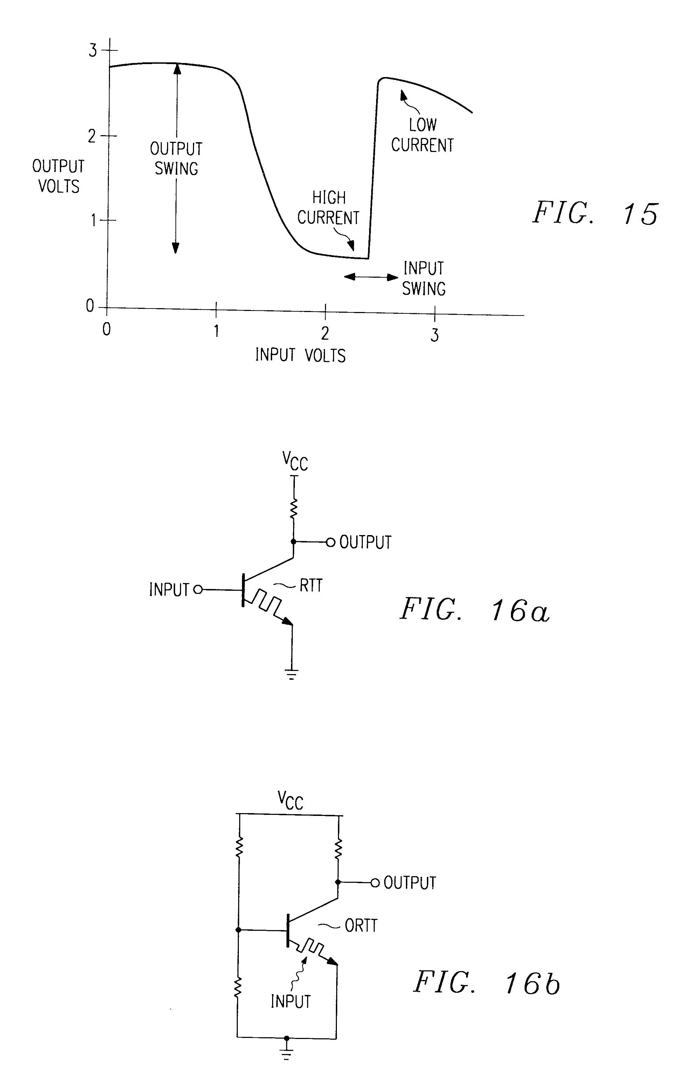

Figure 14b is a energy band diagram for ORTT 1400 with forward emitter-base bias and reverse base-collector bias. The lowest subband edge level within the tunneling well provides the energy filtering for electron injection into the base, as in known resonant tunneling transistors. Figure 15 illustrates the input-output characteristics for such transistors with the input being the base-emitter voltage and the output being the collector-emitter voltage as illustrated by Figure 16a. In particular, when the base-emitter voltage aligns the energy levels for resonant tunneling through the tunneling well, high collector current flows as indicated in Figure 15 and the collector-emitter voltage is small; whereas for slightly larger base-emitter voltage the tunneling well is out of resonance and the collector current falls to a low value as indicated in Figure 15. This provides a gain as shown by the output swing in Figure 15.

Figure 16b shows the circuit connection for ORTT 1400 to use an optical input in place of the electrical input of Figure 16a and still take avantage of the gain illustrated in Figure 15 which ORTD 1000 does not have. In particular, with no input light, set the base-emitter bias to the high current state indicated in Figure 15. Then with an input of light of wavelength in the range of 900 nm to 1.4 mm, the ORTT's collector and emitter will be transparent but the absorber layer will generate electron-hole pairs which separate under the influence of the base-emitter bias and create a screening electric field which effectively increases the electric field across the double barriers and tunneling well and switches the ORTT into the low current state. That is, ORTT 1400 uses the same photogenerated charge pair production mechanism as ORTD 1000 but also has the transistor gain to yield a larger output swing.

A variation of the ORTT is based on a resonant tunneling hot electron transistor with an absorber well in place of the resonant tunneling bipolar transistor with absorber well of ORTT 1400.

### Broadcast optical interconnection system

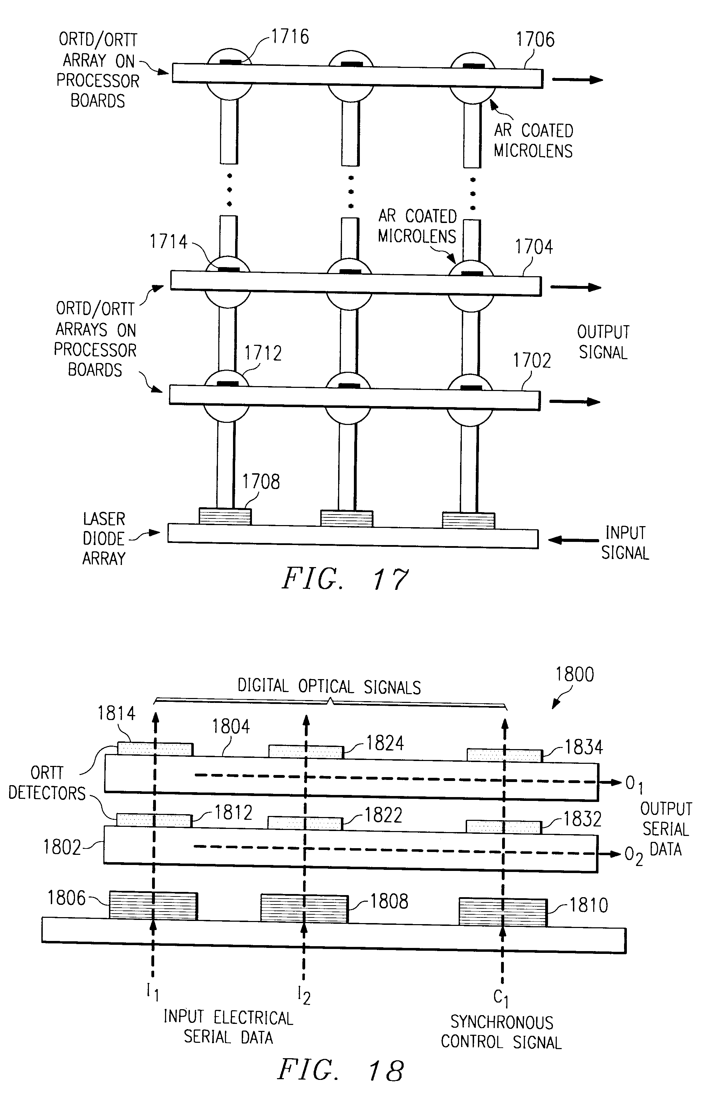

The optical interconnection system 300 when used for general broadcast communication, such as receipt of a global clock which synchronizes various electrical circuits on differing PWBs, can be simplified due to the superfluity of the modulators. For example, Figure 17 shows preferred embodiment system 1700 including laser diode 1708 in an array diodes and optically linked to ORTD/ORTT detectors 1712, 1714,... 1716 on PWBs 1702, 1704, ... 1706. Input signals switch laser diode 1708 off and on, and detectors 1712, 1714, ... 1716 convert these digital optical signals into digital electrical signals for their respective PWBs as previously described. Again, each stack of diode plus detectors runs in parallel. The low absorption by each detector together with anti-reflective optics permits several detectors in series with the last detector still receiving irrradiance above the threshold for switching.

### Reconfigurable optical interconnection switch

The optical interconnection system 1700 and variations can be used as a reconfigurable switch 1800 as illustrated in Figure 18. Switch 1800 has two parallel serial digital electrical signal streams converted to two parallel serial digital optical signal streams by laser diodes 1806 and 1808. The output of diode 1806 is detected by both ORTT detector 1812 on PWB 1802 and ORTT detector 1814 on PWB 1804. Similarly, the output of diode 1808 is detected by ORTT detectors 1822 and 1824. The selection of whether to transmit the output of laser 1806 or 1808 is made by multiplexer logic controlled by signals from laser dioe 1810 and which are detected on PWB 1802 by ORTT detector 1832 and on PWB 1804 by ORTT detector 1834. The control signals would just be a repeating digital code. Thus by changing the code output by laser 1810, the signals from one of diodes 1806 and 1808 may be directed to either of PWB 1802 and 1804 (or both). Clearly, more PWBs and more parallel serial digital optical signal streams could be added; the only complexity would be in the selection codes transmitted by diode 1810 and the multiplexers controlled by the detectors of the diode 1810 signals.

### Mixed listener and listener/talker interconnections

A system could have both "listener/talker" optical interconnections as in Figure 3 and "listener only" optical interconnections as in Figure 17. The listener only portion could provide a synchronizing (clock) signal, and the listener/talker portion provide two-way communication.

### Common optical memory

The optical interconnection system 300 may be used in a common optical memory as follows. An SRAM cell stores a bit which also sets one of two modulators to block light and the other modulator to transmit light simply by having the modulators coupled to the load elements of the cell. Then the stored bit can be transferred to all other cells in a vertical stack by a control signal coupling the detectors in the stack to each cell's drivers after decoupling the drivers from each other.

### Multivalued logic detection

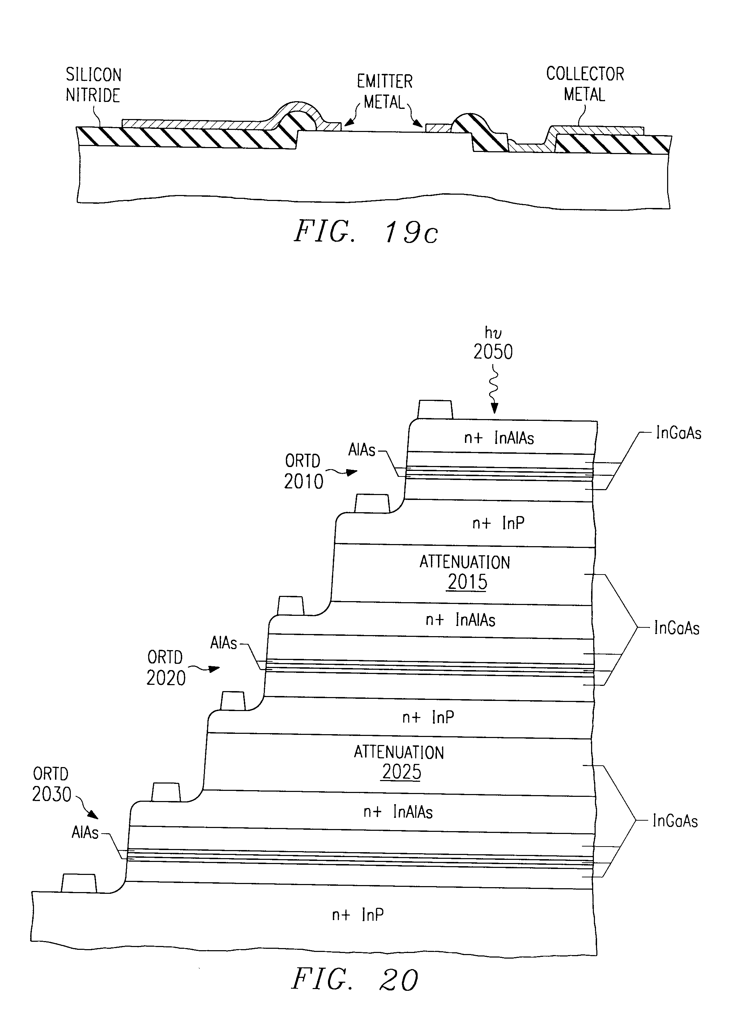

A stack of ORTDs or ORTTs can be used for digital detection of multivalued logic optical signals. In particular, Figure 20 heuristically shows ORTDs 2010, 2020, and 2030 formed in stack 2000 along a vertical light path with InGaAs attenuation layers 2015 and 2025 between the ORTDs; input multiple-valued optical signal 2050 enters stack 2000 at the top in Figure 20. Attenuation layers 2015 and 2025 absorb a fraction of incident light and thereby separate the responses of the ORTDs to the multiple values of the incident optical signal as follows.

First, consider a simple binary-weighted optical signal; that is, the input optical signal has one of four intensities: 0, I, 2I, or 4I where I is some irradiance such as 20 W/cm which leads to a convenient ORTD irradiance threshold in the range I/2 to I. Presume that each ORTD absorbs about 5% of any input optical signal and transmits about 95%. Take the thickness of attenuation layers 2015 and 2025 so that each layer absorbs about 45% of any incident light and transmits about 55%; that is, a combination of ORTD 2010 plus attenuation layer 2015 absorbs 50% and transmits 50%, similarly for the combination of ORTD 2020 and attenuation layer 2025. Then the irradiance at each of the ORTDs for the four possible optical input intensities are as follows:

| Input | ORTD 2010 | ORTD 2020 | ORTD 2030 |
|---|---|---|---|
| 0 | 0 | 0 | 0 |
| I | I | I/2 | I/4 |
| 2I | 2I | I | I/2 |
| 4I | 4I | 2 | I |

Thus with each of the ORTDs having an irradiance threshold between I/2 and I, stack 2000 provides a decoding of the multiple-valued input optical signal with each output being either 0 or the voltage swing of the corresponding ORTD.

Other multiple-valued optical signals, such as three equally spaced intensities, could also be used with analogous stacks of ORTDs or ORTTs. For example, with four equally spaced light intensities (0, I, 2I, and 3I), the ORTD 2010 plus attenuation layer 2015 combination transmitting 50% of incident light, and the ORTD 2020 plus attenuation layer 2025 combination transmitting 67%, then an irradiance threshold between 2I/3 and I will provide the decoding.

### Modifications

The preferred embodiments may be varied in many ways while retaining one or more of the features of optical switching based on screening electric fields produced in an optical absorber adjacent a resonant tunneling device.

For example, altering thickness, composition, or energy gap of the optical signal absorber layer allows for trade offs of speed, transparency (fanout), sensitivity, and optical operating frequency. The resonant tunneling device could have two-, one-, or zero-dimensional quantum wells. Further, the electical current (electrons and holes) through the detectors may be controlled by varying the tunneling barrier thickness, composition, or energy gap such as a two-material barrier, for example, InGaAs with InAlAs plus AlAs in place of AlAs for a tunneling barrier. This gives a two-step conduction band discontinuity. The differing bandgaps of materials available for the tunneling barriers permit separately controlling the electron and hole currents. Additionally, the absorbing layer may have a varying composition, such as a graded bandgap which narrows next to the tunneling barriers. For example, InₓGa₁₋ₓAs with X being graded from 0.53 up to 0.7 next to the tunneling barriers. This permits more effective accumulation of holes or electrons and greater photosensitivity. Similarly, intentionally introducing impurities which provide traps for recombination and thereby altering carrier lifetimes changes the speed and sensitivity of the detector.

Further, the optical links could be combinations of free space propagation and optical fibers or even the ORTD could couple to an integrated waveguide on one (or both) side of the substrate for a substrate edge connection to optical fiber or other optical links.

Preferably, the tunneling barriers are planar and in a mesa.

Preferably the diode includes a region of a first material adjacent said first tunneling barrier, said first material haveing a bandgap less than the bandgap in said quantum well.

Preferably the quantum well is made of any undoped semiconductor material; the first tunneling barrier abuts a first region of said undoped semiconductor material space from said quantum well; said second tunneling barrier abuts a second region of said undoped semiconductor material spaced from said quantum well; and said diode includes doped top contact material abutting said first region and doped bottom contact material abutting said second region with the bandgaps of said top contact material and said bottom contact material are greater than the bandgap of said undoped semiconductor material.

Preferably the undoped semiconductor material is InGaAs; the top contact material is doped InAlAs; and the bottom contact material is doped InP.

Preferably the diode is characterised by room temperature operation.

Also preferably the system comprising, the transparent detectors D*1, D*2, ... D*n with D*j coupled to Dj for each j in the range of 1 to n; optical emitters E*1, E*2, ...E*m; and a second plurality of optical links connecting said D*1, D*2, ... D*n and said E*1, E*2, ...E*m in series.

Also preferably D*j and Dj are located on a common surface. Also preferably the system further comprising, optical modulators M1, M2, ... Mn with Mj coupled to Dj for each j, said Mj connected in series with said transparent dtectors and optical emitters by said optical links.

Also preferably wherein, Mj and Dj are located on a common surface.

Also preferably the integer m equals two; and said optical emitters E1 and E2 are at the ends of said series of said optical link connected detectors, optical emitters and modulators.

Also preferably the system comprising, a mirror at one end of said series of said optical link connected detectors, optical emitters, and modulators; and said integer m equals one with said optical emitter E1 at the end of said series of said optical link connected detectos, optical emitters and moduclators remote from said one end.

Also preferably the optical links include microlenses and ambient atmosphere.

Also prefereably the optical links include optical fibres.

## Claims

1. A transparent photodetector, comprising:
a resonant tunneling diode including a quantum well between first and second tunneling barriers, the absorbance of said diode being less than about 10% of incident light of a frequency to be detected;
a load impedance in series with said diode, said impedance characterized by said diode having (1) a single first stable current-voltage point when (i) a bias voltage is applied across said diode plus impedance in series and (ii) incident light to said diode has an irradiance less than a threshold and (2) a single second stable current-voltage point differing from said first stable current-voltage point when (i) said bias voltage is applied across said diode plus impedance in series and (ii) incident light to said diode has an irradiance greater than said threshold; and
an electrical output between said diode and said impedance.

2. A transparent photodetector, comprising:
a transparent emitter and a transparent collector;
first and second transparent tunneling barriers, said tunneling barriers between said emitter and collector;
a quantum well between said first and second tunneling barriers; and
a transparent light absorbing region adjacent said first tunneling barrier, said region characterized by absorption of at most 10% of incident light at said frequency to be detected;
whereby absorption of light in said absorbing region affects resonant tunneling of carriers through said tunneling barriers and quantum well.

3. A method of photodetection, comprising the steps of:
providing a transparent resonant tunneling diode;
providing a load impedance in series with said diode;
applying a bias across said diode and impedance in series; and
detecting a voltage drop across said impedance;
wherein said bias and impedance are characaterized by said diode having (1) a single first stable current-voltage point when incident light to said diode has an irradiance less than a threshold and (2) a single second stable current-voltage point differing from said first stable current-voltage point when incident light to said diode has an irradiance greater than said threshold.

4. An optical interconnection system, comprising:
transparent detectors D1, D2, ... Dn with n a positive integer greater than one;
optical emitters E1, E2, ... Em with m a positive integer; and
a plurality of optical links connecting said D1, D2, Dn and said E1, E2, ... Em in series.

5. A method of optical communication, comprising the steps of:
providing an optical emitter;
providing a plurality of transparent detectors; and
providing a plurality of optical links to connect said detectors in series to said optical emitter.
